# EUROPEAN PATENT APPLICATION

(11) **EP 2 869 412 A2**
(43) Date of publication of application: **06.05.2015**
(21) Application number: 14190655.2
(22) Date of filing: 28.10.2014
(51) Int. Cl.: H01S 5/0687, G04F 5/14, H01S 5/062, H01S 5/00, H01S 5/0683, H01S 5/183

(54) **Optical module and atomic oscillator**

(30) Priority: 30.10.2013 JP 2013225921
(71) Applicant: Seiko Epson Corporation, Tokyo 163 (JP)
(72) Inventor: Nishida, Tetsuo, Nagano, 392-8502 (JP)
(74) Representative: Hoffmann Eitle

(57) **Abstract**

An optical module of an atomic oscillator includes: a surface emitting laser (10) adapted to emit polarized light; a polarization element (20) irradiated with the light emitted from the surface emitting laser, and having a polarization transmission axis disposed so as to be rotated by 45 degrees with respect to a polarization direction of the polarized light; a λ/4 plate (30) irradiated with light having been transmitted through the polarization element, and having a fast axis disposed so as to be rotated by 45 degrees with respect to the polarization transmission axis; a gas cell (40) encapsulating an alkali metal gas, and irradiated with light having been transmitted through the λ/4 plate; and a light detection section (50) adapted to detect intensity of light having been transmitted through the gas cell. Due to high-frequency modulation of the VCSEL side-bands are generated which are in resonance to the absorption of the alkali metal gas resulting in a very stable atomic clock by using this signal in a feedback loop controlling the VCSEL high frequency modulation.

## Description

### BACKGROUND

### 1. Technical Field

The present invention relates to an optical module and an atomic oscillator.

### 2. Related Art

In recent years, an atomic oscillator using coherent population trapping (CPT) as a quantum interference effect has been proposed, and downsizing and reduction in power consumption of the device have been expected. The atomic oscillator using CPT uses an electromagnetically induced transparency phenomenon (EIT phenomenon) wherein the absorption of coherent light beams respectively having two different wavelengths (frequencies) stops if an alkali metal atom is irradiated with the coherent light beams.

For example, in JP-A-2013-98606, there is disclosed an atomic oscillator in which the resonant light emitted from a light source is converted by a λ/4 plate into circularly polarized light, and the gas cell encapsulating the alkali metal atoms is irradiated with the circularly polarized light in order to increase the probability of the EIT phenomenon occurring. By irradiating the gas cell with the circularly polarized light, it is possible to cause an interaction between the alkali metal atoms and the circularly polarized light to thereby increase the probability of the alkali metal atoms existing in the ground level of magnetic quantum number m_{F}=0. Thus, the occurrence probability of the EIT phenomenon can be increased.

The light generated in a surface emitting laser has a coherent property, and is therefore suitable for obtaining a quantum interference effect. In general, the surface emitting laser emits polarized light.

However, it is known that in a surface emitting laser, the polarization direction of the polarized light to be emitted is changed, namely polarization switching occurs, due to an external factor (e.g., temperature, stress, and aging of the device structure). In the single mode VCSEL used for the atomic oscillator, two polarization directions that are perpendicular to each other are normally allowed. Therefore, in such a VCSEL, since the polarization direction changes from one of the two directions to the other due to the polarization switching, namely the polarization direction rotates 90 degrees, it is not possible to determine the polarization direction of the polarized light to be emitted to one direction.

Therefore, if the vertical cavity surface emitting laser (VCSEL) is applied as a light source of the atomic oscillator of JP-A-2013-98606, the polarization direction of the polarized light to be emitted from the vertical cavity surface emitting laser is changed due to the polarization switching, and there is a problem that the polarization direction of the polarized light entering the λ/4 plate is changed.

### SUMMARY

An advantage of some aspects of the invention is to provide an optical module capable of making the polarization direction of the polarized light entering the λ/4 plate constant even if the polarization direction of the polarized light emitted from the surface emitting laser is changed. Another advantage of some aspects of the invention is to provide an atomic oscillator including the optical module described above.

An optical module according to an aspect of the invention is an optical module of an atomic oscillator, including a surface emitting laser (a light source) adapted to emit polarized light, a polarization element (a polarizer) irradiated with the light emitted from the surface emitting laser, and having a polarization transmission axis disposed so as to be rotated by 45 degrees with respect to a polarization direction of the polarized light, a λ/4 plate irradiated with light having been transmitted through the polarization element, and having a fast axis disposed so as to be rotated by 45 degrees with respect to the polarization transmission axis, a gas cell encapsulating an alkali metal gas, and irradiated with light having been transmitted through the λ/4 plate, and a light detection section (a light detector) adapted to detect an intensity of light having been transmitted through the gas cell.

According to such an optical module, even in the case in which the polarization direction of the polarized light emitted by the surface emitting laser rotates by 90 degrees, the polarization direction of the polarized light entering the λ/4 plate can be set to a constant direction by the polarization element. Further, since the polarization transmission axis of the polarization element is disposed so as to be rotated by 45 degrees with respect to the polarization direction of the polarized light emitted by the surface emitting laser, the light intensity of the polarized light entering the λ/4 plate can be made constant even in the case in which the polarization direction of the polarized light emitted by the surface emitting laser rotates by 90 degrees.

Therefore, according to such an optical module, the rotational direction and the light intensity of the circularly-polarized light with which the gas cell is irradiated can be made constant even in the case in which the polarization direction of the polarized light emitted by the surface emitting laser rotates by 90 degrees. Thus, for example, the frequency stability of the atomic oscillator can be improved.

In the optical module according to the aspect of the invention, the polarization direction of the polarized light emitted from the surface emitting laser may change from a first direction to a second direction perpendicular to the first direction.

According to such an optical module as described above, the rotational direction and the light intensity of the circularly-polarized light with which the gas cell is irradiated can be made constant even in the case in which the polarization direction of the polarized light emitted by the surface emitting laser changes from the first direction to the second direction (rotates by 90 degrees).

An atomic oscillator according to another aspect of the invention includes the optical module according to the aspect of the invention.

According to such an atomic oscillator, since the optical module according to the aspect of the invention is included, the rotational direction and the light intensity of the circularly-polarized light with which the gas cell is irradiated can be made constant even in the case in which the polarization direction of the polarized light emitted by the surface emitting laser rotates by 90 degrees. Thus, the frequency stability, for example, can be improved.

### BRIEF DESCRIPTION OF THE DRAWINGS

Embodiments of the invention will be described with reference to the accompanying drawings, wherein like numbers reference like elements.
Fig. 1 is a block diagram showing an atomic oscillator including an optical module according to an embodiment of the invention.
Fig. 2 is a diagram schematically showing a configuration of the optical module according to the embodiment.
Fig. 3 is a diagram schematically showing the configuration of the optical module according to the embodiment.
Fig. 4 is a diagram showing a frequency spectrum of resonant light.
Fig. 5 is a diagram showing a relationship between a Λ-type three-level model of an alkali metal atom, and a first sideband wave and a second sideband wave.
Fig. 6 is a diagram for explaining a configuration of an optical module according to a reference example.
Fig. 7 is a diagram for explaining the configuration of the optical module according to the reference example.
Fig. 8 is a diagram schematically showing a configuration of a measurement system according to an experimental example.
Fig. 9 is a graph showing a result of evaluation of an I-L characteristic of a surface emitting laser performed via a polarization element.

### DESCRIPTION OF AN EXEMPLARY EMBODIMENT

Hereinafter, a preferred embodiment of the invention will be explained in detail with reference to the accompanying drawings. It should be noted that the embodiment described below does not unreasonably limit the scope of the invention as set forth in the appended claims. Further, all of the constituents explained hereinafter are not necessarily essential elements of the invention.

### 1. Optical Module

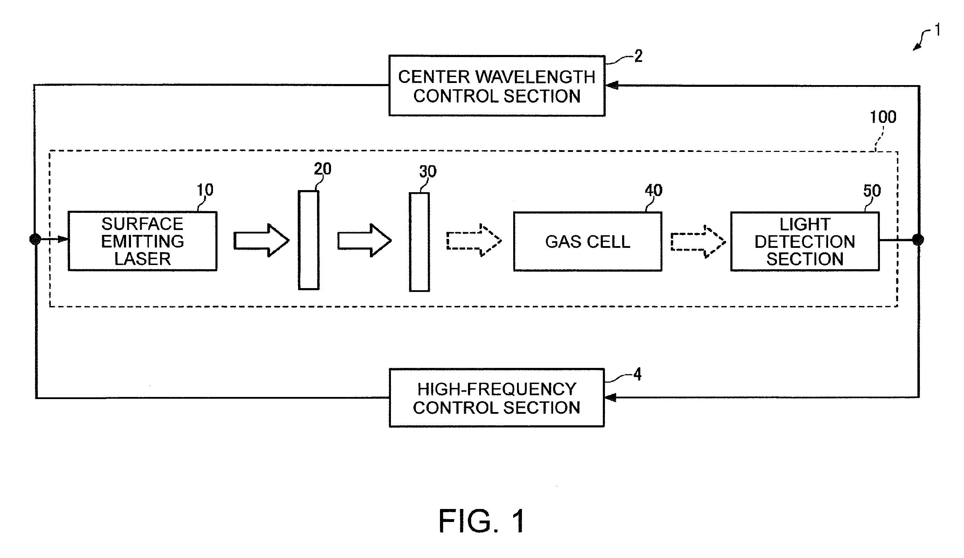

Firstly, an optical module according to the present embodiment will be explained with reference to the accompanying drawings. Here, an example of applying the optical module to an atomic oscillator according to the present embodiment will be explained. Fig. 1 is a block diagram showing the atomic oscillator 1 including the optical module 100 according to the present embodiment.

As shown in Fig. 1, the atomic oscillator 1 is configured including the optical module 100, a center wavelength control section 2, and a high-frequency control section 4.

As shown in Fig. 1, the optical module 100 is includes, in order, a surface emitting laser 10, a polarization element 20, a λ/4 plate 30, a gas cell 40, and a light detection section 50.

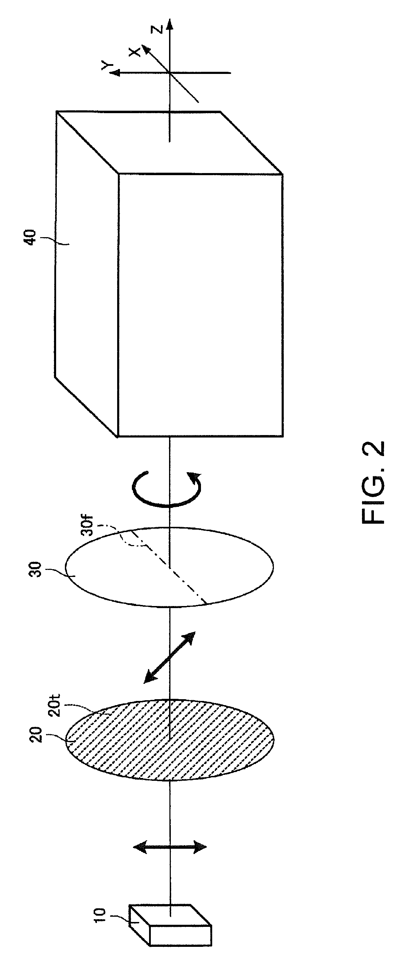

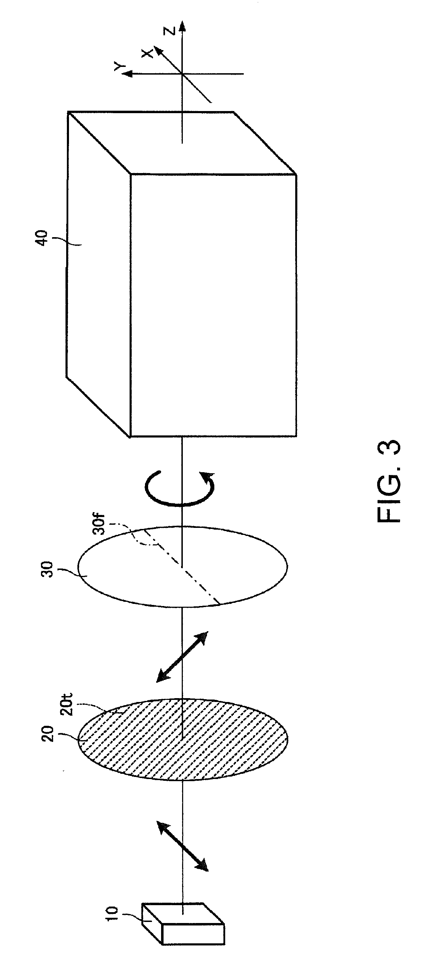

Figs. 2 and 3 are diagrams schematically showing the configuration of the optical module 100. Fig. 2 shows the case in which the polarization direction of the polarized light emitted from the surface emitting laser 10 is the Y direction, and Fig. 3 shows the case in which the polarization direction of the polarized light emitted from the surface emitting laser 10 is the X direction. Note that the X and Y directions are orthogonal to one another. In Figs. 2 and 3, the graphical description of the light detection section 50 is omitted for the sake of convenience.

It should be noted that the Z axis is shown in Figs. 2 and 3 as an axis coinciding with the optical axis of the surface emitting laser 10. Here, the optical axis of the surface emitting laser 10 denotes an axis passing through the center of the light beam emitted from the surface emitting laser 10 (e.g. , light cone). Further, the X axis and the Y axis are shown in Figs. 2 and 3, as axes perpendicular to each other, and perpendicular to the Z axis.

The surface emitting laser 10 is, for example, a vertical cavity surface emitting laser (VCSEL) having a resonator configured perpendicularly to a semiconductor substrate. The surface emitting laser 10 is, for example, a single-mode VCSEL.

The surface emitting laser 10 emits polarized light. Here, the polarized light includes linearly-polarized light and elliptically-polarized light which can be assumed to be substantially linearly-polarized light. The linearly-polarized light denotes light having a vibration direction of the electric field of the light in a single plane. Further, the elliptically-polarized light which can be assumed to be substantially linearly-polarized light denotes elliptically-polarized light having a length of the long axis sufficiently long with respect to the length of the short axis. For example, the elliptically-polarized light has the ratio between the length a of the long axis and the length b of the short axis fulfilling the relationship of b/a ≤ 0.1. Here, the long axis of the elliptically-polarized light denotes the long axis of an ellipse drawn by a tip of a vibration vector of the electric field of the light in the elliptically-polarized light having the tip of the vibration vector making an elliptic motion. Further, the short axis of the elliptically-polarized light denotes the short axis of such an ellipse. It should be noted that in Fig. 1, the polarized light is represented by a solid outlined arrow, and the light (the circularly-polarized light) having the tip of the vibration vector of the electric field making a circular motion is represented by a dashed outlined arrow.

The surface emitting laser 10 may emit polarized light having two directions perpendicular to each other. Therefore, the polarization direction of the polarized light emitted from the surface emitting laser 10 may be either one of the two directions. Here, the polarization direction of the polarized light denotes the vibration direction of the electric field in the linearly-polarized light. Further, the polarization direction of the polarized light denotes the direction of the long axis of the elliptically-polarized light in the elliptically-polarized light which can be assumed to be substantially linearly-polarized light. In the example shown in Figs. 2 and 3, the polarized light in the X direction (a first direction) and the polarized light in the Y direction (a second direction) are allowed in the surface emitting laser 10, and the polarization direction of the polarized light emitted from the surface emitting laser 10 is one of the X direction and the Y direction.

For example, in the case in which the surface emitting laser 10 uses a (100) GaAs substrate as the semiconductor substrate, the polarized light is allowed in a [011] -axis direction (e.g., the X direction) or in a [0-11] -axis direction (e.g., the Y direction). Therefore, the polarization direction of the polarized light emitted from such a surface emitting laser 10 is either one of the [011] -axis direction and the [0-11]-axis direction.

In the surface emitting laser 10, the polarization switching, in which the polarization direction of the polarized light to be emitted is changed, occurs due to an external factor (e.g., temperature, stress, and aging of a device structure). In the surface emitting laser 10, the polarization direction is changed from one (the first direction) of the two directions in which the polarization is allowed to the other (the second direction) thereof due to the polarization switching. For example, in the surface emitting laser 10, if the polarization switching occurs in the case in which the polarization direction of the polarized light to be emitted is the Y direction (see Fig. 2), the polarization direction of the polarized light to be emitted changes to the X direction (see Fig. 3). Further, in the surface emitting laser 10, if the polarization switching occurs in the case in which the polarization direction of the polarized light to be emitted is the X direction (see Fig. 3), the polarization direction of the polarized light to be emitted changes to the Y direction (see Fig. 2).

For example, in the case in which the surface emitting laser 10 uses the (100) GaAs substrate as the semiconductor substrate, if the polarization switching occurs in the case in which the polarization direction of the polarized light to be emitted from the surface emitting laser 10 is the [011]-axis direction, the polarization direction of the polarized light to be emitted changes to the [0-11]-axis direction. Further, if the polarization switching occurs in the case in which the polarization direction of the polarized light to be emitted from the surface emitting laser 10 is the [0-11]-axis direction, the polarization direction of the polarized light to be emitted changes to the [011]-axis direction.

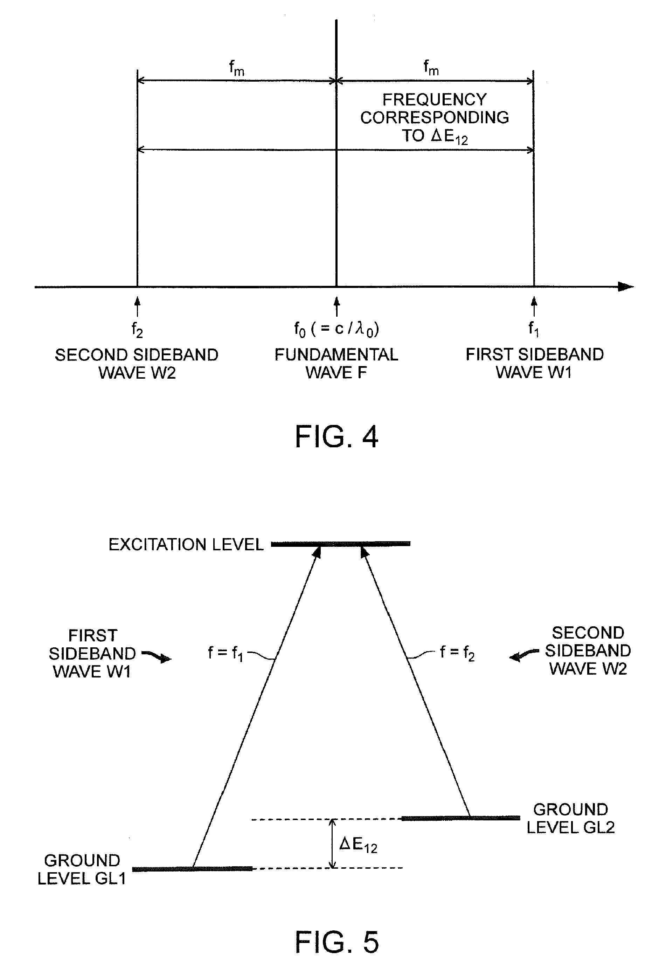

Fig. 4 is a diagram showing a frequency spectrum of the light emitted by the surface emitting laser 10. Fig. 5 is a diagram showing a relationship between a Λ-type three-level model of the alkali metal atom, and a first sideband wave W1 and a second sideband wave W2. The light emitted from the surface emitting laser 10 includes a fundamental wave F having the center frequency f₀ (=c/λ₀: c denotes the speed of light; and λ₀ denotes the center wavelength), the first sideband wave W1 having the frequency f₁ in the upper sideband with respect to the center frequency f₀, and the second sideband wave W2 having the frequency f₂ in the lower sideband with respect to the center frequency f₀ shown in Fig. 4. The frequency f₁ of the first sideband wave W1 is obtained as f₁=f₀+fₘ, and the frequency f₂ of the second sideband wave W2 is obtained as f₂=f₀-fₘ.

As shown in Fig. 5, the frequency difference between the frequency f₁ of the first sideband wave W1 and the frequency f₂ of the second sideband wave W2 coincides with the frequency corresponding to the energy difference ΔE₁₂ between the ground level GL1 and the ground level GL2 of the alkali metal atom. Therefore, the alkali metal atom causes the EIT phenomenon with the first sideband wave W1 having the frequency f₁ and the second sideband wave W2 having the frequency f₂.

The polarization element 20 is, for example, a polarization plate for transmitting only the light polarized in the direction of a polarization transmission axis 20t out of the incident light. Here, the polarization transmission axis 20t denotes an axis for transmitting the vibration of the electric field of the light. The polarization transmission axis 20t of the polarization element 20 is disposed so as to be rotated by 45 degrees with respect to the polarization direction of the polarized light emitted from the surface emitting laser 10. In other words, the polarization transmission axis 20t of the polarization element 20 is disposed so as to be tilted by 45 degrees around the optical axis with respect to the polarization direction of the polarized light emitted from the surface emitting laser 10.

Since the polarization direction of the polarized light emitted from the surface emitting laser 10 is either one of the two directions (the X direction and the Y direction) perpendicular to each other, the polarization transmission axis 20t of the polarization element 20 is disposed so as to form an angle of 45 degrees with both of the two directions. For example, in the case in which the surface emitting laser 10 uses the (100) GaAs substrate as the semiconductor substrate, the polarization direction of the polarized light to be emitted from the surface emitting laser 10 is one of the [011] -axis direction and the [0-11]-axis direction. Therefore, the polarization transmission axis 20t of the polarization element 20 is disposed so as to form an angle of 45 degrees with respect to both of the [011] -axis direction and the [0-11] -axis direction.

In the example shown in Figs. 2 and 3, the polarization direction of the polarized light emitted from the surface emitting laser 10 is one of the X direction and the Y direction. Therefore, the polarization transmission axis 20t of the polarization element 20 is disposed so as to rotate (be tilted) clockwise by 45 degrees with respect to the Y axis toward the propagating direction of the polarized light. In other words, the polarization transmission axis 20t of the polarization element 20 is disposed so as to rotate (be tilted) counterclockwise by 45 degrees with respect to the X axis toward the propagating direction of the polarized light.

It should be noted that although not shown in the drawings, the polarization transmission axis 20t of the polarization element 20 can also be disposed so as to rotate (be tilted) counterclockwise by 45 degrees with respect to the Y axis toward the propagating direction of the polarized light.

The polarization element 20 is irradiated with the light emitted from the surface emitting laser 10. In the example shown in Fig. 2, the polarization direction of the polarized light emitted from the surface emitting laser 10 is the Y direction. Therefore, the light transmitted through the polarization element 20 becomes polarized light polarized in the direction tilted by 45 degrees clockwise with respect to the Y axis (counterclockwise with respect to the X axis) toward the propagating direction of the polarized light. Further, in the example shown in Fig. 3, the polarization direction of the polarized light emitted from the surface emitting laser 10 is the X direction. Therefore, the light transmitted through the polarization element 20 becomes polarized light polarized in the direction tilted by 45 degrees clockwise with respect to the Y axis (counterclockwise with respect to the X axis) toward the propagating direction of the polarized light similarly to the example shown in Fig. 2.

As described above, even in the case in which the polarization direction of the polarized light emitted from the surface emitting laser 10 rotates by 90 degrees (i.e., the polarization direction is changed from the Y direction to the X direction), the light transmitted through the polarization element 20 becomes polarized light having the same polarization direction.

Further, in the case in which the light intensity of the polarized light emitted from the surface emitting laser 10 is the same, the light intensity (transmitted light intensity) of the light transmitted through the polarization element 20 becomes the same between the case in which the polarization direction of the polarized light having entered the polarization element 20 is the Y direction (the case of Fig. 2) and the case in which the polarization direction of the polarized light having entered the polarization element 20 is the X direction (the case of Fig. 3). This is because the angle formed between the polarization direction (the X direction or the Y direction) of the polarized light entering the polarization element 20 and the polarization transmission axis 20t of the polarization element 20 is the same angle (45 degrees) among the case of Fig. 2 and the case of Fig. 3.

It should be noted that the light intensity of the light having been transmitted through the polarization element 20 is decreased (e.g., roughly 1/2) compared to the light intensity of the light when entering the polarization element 20. However, the decrease in light intensity in the polarization element 20 does not affect the operation of the atomic oscillator 1.

The λ/4 plate 30 is a wave plate for providing an optical path difference (a phase difference of 90°) of a quarter wavelength between the linearly-polarized light components of light that is perpendicular to each other. The λ/4 plate 30 converts the polarized light having a direction tilted by 45 degrees with respect to a fast axis 30f as the polarization direction into circularly-polarized light when the polarized light enters the λ/4 plate 30. Here, the fast axis 30f denotes an axis in a direction along which the λ/4 plate has a low refractive index, and is an axis perpendicular to a slow axis (an axis along which the λ/4 plate has a high refractive index) of the λ/4 plate. As the λ/4 plate 30, for example, a quartz crystal plate or a mica plate can be used.

The λ/4 plate 30 is irradiated with the light having been transmitted through the polarization element 20. In other words, the λ/4 plate 30 is irradiated with the light (the polarized light having the direction of the polarization transmission axis 20t as the polarization direction) polarized in the direction of the polarization transmission axis 20t of the polarization element 20.

The λ/4 plate 30 is disposed so that the fast axis 30f is rotated by 45 degrees with respect to the polarization transmission axis 20t of the polarization element 20. In other words, the fast axis 30f of the λ/4 plate 30 is disposed so as to be tilted by 45 degrees around the optical axis with respect to the polarization transmission axis 20t of the polarization element 20. Thus, the polarization direction of the polarized light entering the λ/4 plate 30 has an angle tilted by 45 degrees with respect to the fast axis 30f of the λ/4 plate 30. Therefore, the polarized light (the linearly-polarized light) having entered the λ/4 plate 30 is converted into circularly-polarized light.

In the example shown in Figs. 2 and 3, the polarized light, which is polarized in the direction tilted by 45 degrees clockwise with respect to the Y axis (counterclockwise with respect to the X axis) toward the propagating direction of the polarized light, enters the λ/4 plate 30. The fast axis 30f of the λ/4 plate 30 is disposed parallel to the X axis. Therefore, the angle of 45 degrees is formed between the fast axis 30f of the λ/4 plate 30 and the polarization direction of the polarized light entering the λ/4 plate 30, and the polarized light having entered is converted by the λ/4 plate 30 into circularly-polarized light. More specifically, the polarized light having entered the λ/4 plate 30 is converted by the λ/4 plate 30 into circularly-polarized light having the clockwise rotational direction, namely right circularly-polarized light. Here, the rotational direction of the circularly-polarized light denotes the rotational direction (clockwise, counterclockwise) when viewing a circle drawn by the tip of the vibration vector of the electric field of the light from the propagating direction of the light in the circularly-polarized light having the tip of the vibration vector making a circular motion. Therefore, the right circularly-polarized light denotes circularly-polarized light having the circle drawn by the tip of the vibration vector of the electric field of the light rotates clockwise viewed from the propagating direction of the light in the circularly-polarized light having the tip of the vibration vector making a circular motion.

It should be noted that although the case in which the λ/4 plate 30 converts the polarized light having entered the λ/4 plate 30 into the right circularly-polarized light is explained here, it is also possible for the λ/4 plate 30 to convert the polarized light having entered the λ/4 plate 30 into left circularly-polarized light. In other wards, for example, in the example shown in Figs. 2 and 3, the fast axis 30f of the λ/4 plate 30 can also be disposed parallel to the Y axis.

The gas cell 40 has the gaseous alkali metal atoms (e.g., sodium atoms, rubidium atoms, or cesium atoms) encapsulated in a container. When the gas cell 40 is irradiated with the two light waves having the difference in frequency (wavelength) corresponding to the energy difference between the two ground levels of the alkali metal atom, the alkali metal atom causes the EIT phenomenon. If, for example, the alkali metal atom is a cesium atom, the frequency corresponding to the energy difference between the ground level GL1 at the D1 line and the ground level GL2 is 9.19263... GHz, and therefore, the EIT phenomenon occurs in response to the irradiation with the two light waves having the frequency difference of 9.19263... GHz.

The gas cell 40 is irradiated with the light (the circularly-polarized light) having been transmitted through the λ/4 plate 30. Thus, the occurrence probability of the EIT phenomenon can be increased. Further, as described above, in the optical module 100, the rotational direction and the light intensity of the circularly-polarized light with which the gas cell 40 is irradiated can be made constant even in the case in which the polarization direction of the polarized light emitted from the surface emitting laser 10 rotates by 90 degrees.

The light detection section 50 detects the intensity of the light transmitted through the alkali metal atom encapsulated in the gas cell 40. The light detection section 50 outputs a detection signal corresponding to the amount of the light having been transmitted through the alkali metal atom. As the light detection section 50, a photo diode, for example can be used.

The center wavelength control section 2 generates a drive current having a level corresponding to the detection signal output by the light detection section 50 and then supplied the surface emitting laser 10 with the drive current to thereby control the center wavelength λ₀ of the light emitted by the surface emitting laser 10. The center wavelength λ₀ of the light emitted by the surface emitting laser 10 is fine tuned and then stabilized by a feedback loop passing through the surface emitting laser 10, the gas cell 40, the light detection section 50, and the center wavelength control section 2.

The high-frequency control section 4 performs control so that the difference in wavelength (frequency) between the first sideband wave W1 and the second sideband wave W2 becomes equal to the frequency corresponding to the difference in energy between the two ground levels of the alkali metal atom encapsulated in the gas cell 40 based on the detection result output by the light detection section 50. The high-frequency control section 4 generates a modulation signal having a modulation frequency fₘ (see Fig. 4) corresponding to the detection result output by the light detection section 50.

The feedback control is performed by the feedback loop passing through the surface emitting laser 10, the gas cell 40, the light detection section 50, and the high-frequency control section 4 so that the frequency difference between the first sideband wave W1 and the second sideband wave W2 coincides with the frequency corresponding to the energy difference between the two ground levels of the alkali metal atom with great accuracy. As a result, since the modulation frequency fₘ becomes an extremely stable frequency, the modulation signal can be used as the output signal (clock output) of the atomic oscillator 1.

### 2. Operation of Optical Module

Next, an operation of the optical module 100 will be explained with reference to Figs. 1 through 3.

The surface emitting laser 10 emits polarized light. The polarized light emitted from the surface emitting laser 10 enters the polarization element 20. Here, the polarization element 20 is disposed so that the polarization transmission axis 20t is rotated by 45 degrees with respect to the polarization direction of the polarized light emitted from the surface emitting laser 10. Therefore, as shown in Figs. 2 and 3, the polarization direction and the light intensity of the polarized light having been transmitted through the polarization element 20 are constant even in the case in which the polarization direction of the polarized light output by the surface emitting laser 10 rotates by 90 degrees.

The polarized light having been transmitted through the polarization element 20 enters the λ/4 plate 30. The λ/4 plate 30 is disposed so that the fast axis 30f is rotated by 45 degrees with respect to the polarization transmission axis 20t of the polarization element 20. Therefore, the polarized light (the linearly-polarized light) having been transmitted through the λ/4 plate 30 becomes circularly-polarized light. In the optical module 100, since the polarization direction and the light intensity of the polarized light entering the λ/4 plate 30 are constant even in the case in which the polarization direction of the polarized light emitted by the surface emitting laser 10 rotates by 90 degrees, the rotational direction and the light intensity of the circularly-polarized light with which the gas cell 40 is irradiated can be made constant.

The light (the circularly-polarized light) having been transmitted through the λ/4 plate 30 enters the gas cell 40. The light emitted from the surface emitting laser 10 includes the two light waves (the first sideband wave W1 and the second sideband wave W2) having a difference in frequency (wavelength) corresponding to the energy difference between the two ground levels of the alkali metal atom, and the alkali metal atom causes the EIT phenomenon. The intensity of the light having been transmitted through the gas cell 40 is detected by the light detection section 50.

The center wavelength control section 2 and the high-frequency control section 4 perform feedback control so that the frequency difference between the first sideband wave W1 and the second sideband wave W2 coincides with the frequency corresponding to the energy difference between the two ground levels of the alkali metal atom with great accuracy. In the atomic oscillator 1, by detecting and then controlling the steep variation in the light absorption behavior occurring when the frequency difference f₁-f₂ between the first sideband wave W1 and the second sideband wave W2 is shifted from the frequency corresponding to the energy difference ΔE₁₂ between the ground level GL1 and the ground level GL2 using the EIT phenomenon, a highly accurate oscillator can be manufactured.

### 3. Features of Optical Module

The optical module 100 according to the present embodiment has, for example, the following features.

The optical module 100 includes the surface emitting laser 10 for emitting the polarized light, the polarization element 20 irradiated with the light emitted from the surface emitting laser 10, and having the polarization transmission axis 20t disposed so as to be rotated by 45 degrees with respect to the polarization direction of the polarized light, and the λ/4 plate 30 irradiated with the light having been transmitted through the polarization element 20, and having the fast axis 30f disposed so as to be rotated by 45 degrees with respect to the polarization transmission axis 20t. Thus, even in the case in which the polarization direction of the polarized light emitted by the surface emitting laser 10 rotates by 90 degrees, the polarization direction of the polarized light entering the λ/4 plate 30 can be set to a constant direction by the polarization element 20. Therefore, the rotational direction of the circularly-polarized light with which the gas cell 40 is irradiated can be made constant. Hereinafter, some advantages will be explained.

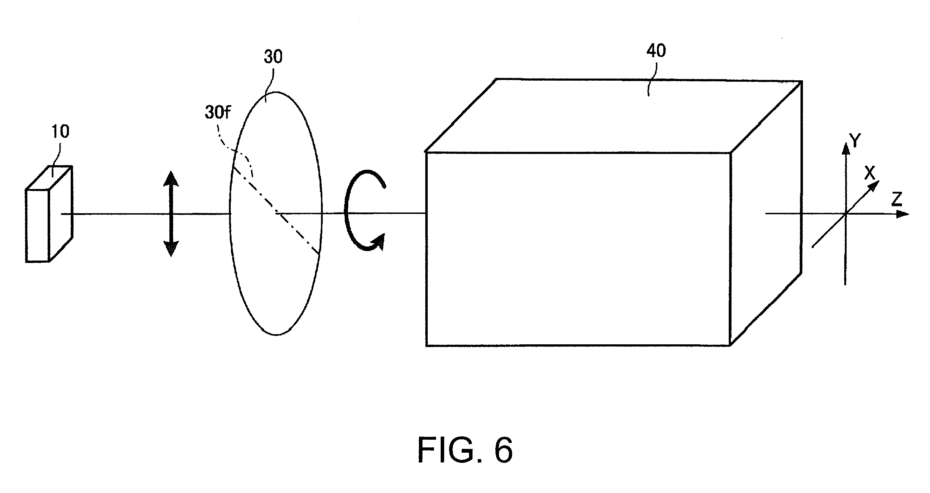

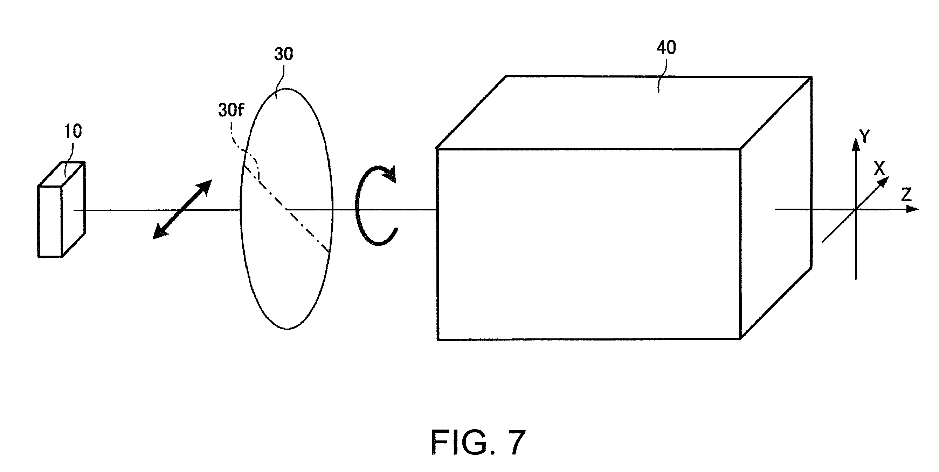

Figs. 6 and 7 are diagrams for explaining a configuration of an optical module according to a reference example. In the optical module according to the reference example, no polarization element 20 is provided, and the light emitted from the surface emitting laser 10 directly enters the λ/4 plate 30. Fig. 6 shows the case in which the polarization direction of the polarized light emitted from the surface emitting laser 10 is the Y direction, and Fig. 7 shows the case in which the polarization direction of the polarized light emitted from the surface emitting laser 10 is the X direction. It should be noted that the Z axis is shown in Figs. 6 and 7 as an axis coinciding with the optical axis of the surface emitting laser 10. Further, the X axis and the Y axis are shown in Figs. 6 and 7, as axes perpendicular to each other, and perpendicular to the Z axis.

As shown in Fig. 6, in the case in which the polarization direction of the polarized light emitted from the surface emitting laser 10 is the Y direction, the light having been transmitted through the λ/4 plate 30 becomes right circularly-polarized light which is the circularly-polarized light having the clockwise rotational direction. Further, as shown in Fig. 7, in the case in which the polarization direction of the polarized light emitted from the surface emitting laser 10 is the X direction, the light having been transmitted through the λ/4 plate 30 becomes left circularly-polarized light which is the circularly-polarized light having the counterclockwise rotational direction.

As described above, in the optical module according to the reference example, if the polarization direction of the polarized light emitted by the surface emitting laser 10 rotates by 90 degrees, the rotational direction of the circularly-polarized light entering the gas cell 40 is changed. If the rotational direction of the circularly-polarized light with which the gas cell 40 is irradiated is changed (changed from clockwise to counterclockwise, or changed from counterclockwise to clockwise), the S/N ratio of the EIT signal instantaneously varies due to the variation in population of the alkali metal atom due to the change in the rotational direction of the circularly-polarized light, and thus, the frequency stability of the atomic oscillator is degraded in some cases, for example.

In contrast, according to the optical module 100, the rotational direction of the circularly-polarized light with which the gas cell 40 is irradiated can be made constant even in the case in which the polarization direction of the polarized light emitted by the surface emitting laser 10 rotates by 90 degrees. Therefore, according to the optical module 100, since the problem described above does not occur, the frequency stability of the atomic oscillator 1 can be improved.

Further, in the optical module 100, since the polarization transmission axis 20t of the polarization element 20 is disposed so as to be rotated by 45 degrees with respect to the polarization direction of the polarized light emitted by the surface emitting laser 10, the light intensity of the polarized light entering the λ/4 plate 30 can be made constant even in the case in which the polarization direction of the polarized light emitted by the surface emitting laser 10 rotates by 90 degrees. Thus, the light intensity of the light (the circularly-polarized light) from the λ/4 plate 30, and with which the gas cell 40 is irradiated, can be made constant.

For example, if the light intensity of the light with which the gas cell is irradiated is varied, the wavelength (frequency) of the light absorbed by the alkali metal atoms varies due to the AC Stark effect to thereby degrade the frequency stability of the atomic oscillator in some cases.

In the optical module 100, since the light intensity of the light with which the gas cell 40 is irradiated can be made constant even in the case in which the polarization direction of the polarized light emitted by the surface emitting laser 10 rotates by 90 degrees, the problem described above does not occur, and thus, the frequency stability of the atomic oscillator 1 can be improved.

As described above, according to the optical module 100, the rotational direction and the light intensity of the circularly-polarized light with which the gas cell 40 is irradiated can be made constant even in the case in which the polarization direction of the polarized light emitted by the surface emitting laser 10 rotates by 90 degrees, and thus, the frequency stability of the atomic oscillator 1 can be improved.

Further, in the optical module 100, since the polarized light emitted from the surface emitting laser 10 enters the λ/4 plate 30 via the polarization element 20 having the polarization transmission axis 20t rotated by 45 degrees with respect to the polarization direction of the polarized light, even in the case in which the polarization direction of the polarized light emitted by the surface emitting laser 10 rotates by 90 degrees, a good I-L characteristic (a drive current to light output characteristic) can be obtained in the surface emitting laser 10 through the polarization element 20 (see the following experimental example).

It should be noted that the embodiment described above is illustrative only, and the invention is not limited thereto.

For example, although in the above description of the embodiment there is explained the case in which the polarization element 20 has the polarization transmission axis 20t rotated by 45 degrees with respect to the polarization direction of the polarized light emitted from the surface emitting laser 10, it is also possible for the polarization element 20 to have the polarization transmission axis 20t rotated within a range of no lower than 44 degrees and no higher than 46 degrees with respect to the polarization direction of the polarized light emitted from the surface emitting laser 10. In other words, it is also possible for the angle formed between the polarization transmission axis 20t of the polarization element 20 and the polarization direction of the polarized light emitted from the surface emitting laser 10 to be within the range of no smaller than 44 degrees and no larger than 46 degrees. In such a case, even if the polarization direction of the polarized light emitted from the surface emitting laser 10 rotates by 90 degrees, the variation in light intensity of the polarized light entering the λ/4 plate 30 can be decreased compared to the case in which, for example, the polarized light emitted from the surface emitting laser 10 directly enters the λ/4 plate 30.

Further, for example, although in the above description of the embodiment, there is explained the case in which the fast axis 30f of the λ/4 plate 30 is disposed so as to be rotated by 45 degrees with respect to the polarization transmission axis 20t of the polarization element 20, the fast axis 30f of the λ/4 plate 30 can also be disposed so as to rotate within a range of no smaller than 44 degrees and no larger than 46 degrees with respect to the polarization transmission axis 20t of the polarization element 20. In other words, it is also possible for the angle formed between the fast axis 30f of the λ/4 plate 30 and the polarization transmission axis 20t of the polarization element 20 to be within the range of no smaller than 44 degrees and no larger than 46 degrees. Even in such a case, it is possible to obtain the light having been transmitted through the λ/4 plate 30 as the circularly-polarized light or the elliptically-polarized light, which can be substantially assumed to be circularly-polarized light, and the occurrence probability of the EIT phenomenon can be increased.

### 4. Experimental Example

Hereinafter, an experimental example will be described, and the present embodiment of the invention will specifically be explained. It should be noted that the scope of the invention is not at all limited by the following experimental example.

### (1) Configuration of Measurement System

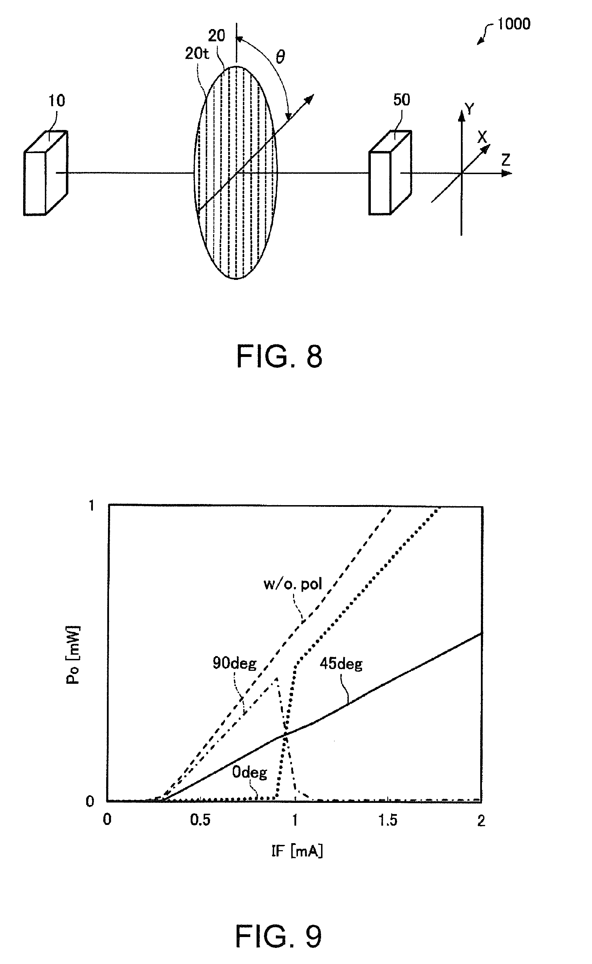

Fig. 8 is a diagram schematically showing a configuration of a measurement system 1000 according to the present experimental example. As shown in Fig. 8, the measurement system 1000 according to the present experimental example includes the surface emitting laser 10, the polarization element 20, and the light detection section 50.

In the present experimental example, the light emitted from the surface emitting laser 10 was made to enter the polarization element 20, the light intensity of the light transmitted through the polarization element 20 was detected using the light detection section 50, and then the I-L characteristic (the drive current to light output characteristic) was evaluated. In other words, the I-L characteristic of the surface emitting laser 10 was evaluated through the polarization element 20. It should be noted that the polarization direction of the polarized light emitted from the surface emitting laser 10 was set to either of the X direction and the Y direction. Further, the polarization transmission axis 20t of the polarization element 20 was made variable, and the evaluation was performed in the cases in which the angle θ formed between the polarization transmission axis 20t and the X axis was 0 degrees, 45 degrees, and 90 degrees, respectively.

Further, as the reference example, the evaluation was performed in the case in which the polarization element 20 was removed from the measurement system 1000 shown in Fig. 8, and the light intensity of the light emitted from the surface emitting laser 10 was directly detected by the light detection section 50.

### (2) Result

Fig. 9 is a graph showing a result of evaluation of the I-L characteristic of the surface emitting laser 10 performed through the polarization element 20. The horizontal axis of the graph shown in Fig. 9 represents the drive current IF of the surface emitting laser 10, and the vertical axis represents the light output (the intensity of the light detected by the light detection section 50) P₀. In Fig. 9, the result (θ=0 deg) in the case in which the angle θ is 0 degrees is indicated by a dotted line, the result (θ=45 deg) in the case in which the angle θ is 45 degrees is indicated by a solid line, the result (θ=90 deg) in the case in which the angle θ is 90 degrees is indicated by a dashed-dotted line, and the result (w/o. pol) in the case in which the light emitted from the surface emitting laser 10 is directly measured using the light detection section 50 is indicated by a broken line.

As shown in Fig. 9, in the case in which the drive current IF is in a range of 0.3 mA through 0.9 mA, the light is hardly detected at θ=0 deg, and the intensity P₀, which is roughly the same as the intensity P₀ of w/o. pol, is detected at θ=90 deg. Therefore, the polarization direction of the polarized light emitted from the surface emitting laser 10 is the Y direction. It should be noted that the difference between the intensity P₀ of w/o. pol and the intensity P₀ at θ=90 deg on this occasion corresponds to the transmittance of the polarization element 20.

In the case in which the drive current IF is equal to or higher than 1 mA, the light is hardly detected at θ=90 deg, and the intensity P₀, which is roughly the same as the intensity P₀ of w/o. pol, is detected at θ=0 deg. Therefore, the polarization direction of the polarized light emitted from the surface emitting laser 10 is the X direction. It should be noted that the difference between the intensity P₀ of w/o. pol and the intensity P₀ at θ=0 deg on this occasion corresponds to the transmittance of the polarization element 20.

Here, the line of θ=0 deg and the line of θ=90 deg intersect with each other in the vicinity of the point where the drive current IF is 0.9 mA. In other words, the polarization switching occurs, the polarization direction of the polarized light emitted from the surface emitting laser 10 changes.

As described above, it is understood that the intensity P₀ of the light significantly varies in the vicinity of the polarization switching (in the vicinity of the point where the drive current IF=0.9 mA) at the angles θ=0 deg and θ=90 deg.

In contrast, it was understood that at the angle θ=45 deg, the line was straight and continuous in the vicinity of the polarization switching (in the vicinity of the point where the drive current IF=0.9 mA), and the intensity P₀ increased roughly in proportion to the drive current IF in the range of the drive current IF of 0.3 mA through 2 mA. As described above, it was figured out that the I-L characteristic of the surface emitting laser 10 through the polarization element 20 with the angle θ=45 deg was not affected by the polarization switching.

The invention includes configurations (e.g., configurations having the same function, the same way, and the same result, or configurations having the same object and the same advantage) substantially the same as the configuration described as the embodiment of the invention. Further, the invention includes configurations obtained by replacing a non-essential part of the configuration described as the embodiment of the invention. Further, the invention includes configurations exerting the same functions and advantages and configurations capable of achieving the same object as the configuration described as the embodiment of the invention. Further, the invention includes configurations obtained by adding known technologies to the configuration described as the embodiment of the invention.

## Claims

1. An optical module of an atomic oscillator, comprising:
a surface emitting laser adapted to emit polarized light;
a polarization element adapted to be irradiated with the polarized light emitted from the surface emitting laser, and the polarization element having a polarization transmission axis rotated by 45 degrees with respect to a polarization direction of the polarized light;
a λ/4 plate adapted to be irradiated with light having been transmitted through the polarization element, and the λ/4 plate having a fast axis rotated by 45 degrees with respect to the polarization transmission axis;
a gas cell encapsulating an alkali metal gas, and the gas cell being adapted to be irradiated with light having been transmitted through the λ/4 plate; and
a light detector adapted to detect an intensity of light having been transmitted through the gas cell.

2. The optical module according to Claim 1, wherein the polarization direction of the polarized light emitted from the surface emitting laser changes from a first direction to a second direction perpendicular to the first direction.

3. An atomic oscillator comprising:
the optical module according to Claim 1 or 2.
